# EUROPEAN PATENT SPECIFICATION

(11) **EP 2 579 693 B1**
(45) Date of publication and mention of the grant of the patent: **11.05.2016**
(21) Application number: 11786794.5
(22) Date of filing: 28.05.2011
(51) Int. Cl.: H05K 1/02, H01L 23/13, H05K 3/00, B32B 3/26, B32B 3/30, H05K 1/03, H05K 3/28

(54) **MULTI-CHIP WIRING BOARD AND PROCESS FOR PRODUCING SAME, AND WIRING BOARD AND PROCESS FOR PRODUCING SAME**
MEHRCHIP-LEITERPLATTE UND VERFAHREN ZU DEREN HERSTELLUNG SOWIE LEITERPLATTE UND VERFAHREN ZU DEREN HERSTELLUNG
CARTE DE CIRCUIT IMPRIMÉ MULTIPUCE ET SON PROCÉDÉ DE PRODUCTION, ET CARTE DE CIRCUIT IMPRIMÉ ET SON PROCÉDÉ DE PRODUCTION

(30) Priority: 28.06.2010 JP 2010146462; 28.05.2010 JP 2010122943
(43) Date of publication of application: 10.04.2013
(73) Proprietor: Kyocera Corporation, Kyoto-shi, Kyoto 612-8501 (JP)
(72) Inventor: NIINO, Noritaka, Kirishima-shi Kagoshima 899-4396 (JP); OCHI, Masaya, Kirishima-shi Kagoshima 899-4396 (JP)
(74) Representative: Viering, Jentschura & Partner mbB Patent- und Rechtsanwälte
(86) International application number: PCT/JP2011/062299
(87) International publication number: WO 2011/149097

(56) References cited:
- JP-A- 2000 252 379
- JP-A- 2005 317 927
- JP-A- 2005 317 927
- US-A1- 2005 009 235

## Description

### Technical field

The invention relates to a segmentable wiring board for production of wiring substrates applicable for example to semiconductor device housing packages and a method for producing the segmentable wiring board, and a wiring substrate and a method for producing the wiring substrate.

### Background Art

Electronic apparatuses for use in, e.g., the field of mobile communication technology employ a semiconductor device housing package including a wiring substrate, a metal frame body, and a lid body, for accommodating a semiconductor device in its interior.

The first step to produce the semiconductor device housing package is preparation of a segmentable wiring board having a plurality of wiring substrate segment regions, which is finally divided into separate wiring substrates.

The segmentable wiring board includes wiring layers and through conductors inside a ceramic base body which are formed in each wiring substrate regions. Such a segmentable wiring board is obtained as follows. First, an organic binder, a plasticizer, a solvent, and so forth are added to ceramic powder to form a slurry, and the slurry is shaped into ceramic green sheets by the doctor blade method or otherwise. Then, wiring patterns are formed on the ceramic green sheets for each wiring substrate region by the printing of a metal powder-containing conductor paste or otherwise. Next, a ceramic-green-sheet stacked body is obtained by stacking a plurality of ceramic green sheets with the wiring patterns on top of each other and applying pressure to the stacked ceramic green sheets, and the ceramic-green-sheet stacked body is fired.

In general, in one main surface of the segmentable wiring board thus obtained are formed V-shaped dividing grooves for defining a plurality of wiring substrate segment regions to facilitate segmentation of the substrate into separate substrates. As a method for forming the dividing grooves, application of laser light to the surface of the ceramic base body is known (refer to

### Patent Literature 1).

It is also known that, on one main surface of the segmentable wiring board, a conductor coated with a metal plating film is formed so as to lie in a periphery of each wiring substrate segment region. This is intended to ensure that a wiring substrate and a metal frame body are firmly bonded to each other by brazing in the subsequent process of producing a semiconductor device housing package.

In order to form dividing grooves in the segmentable wiring board formed with the metal plating film-coated conductor positioned in the periphery of each wiring substrate segment region, the following method can be considered: no metal plating film-coated conductor is formed along a demarcation line where a dividing groove for defining a plurality of wiring substrate segment regions is to be created so that an insulating base body can be left exposed, and, under this condition, laser light is applied along the demarcation line following the completion of firing of a ceramic-green-sheet stacked body, thereby forming the dividing groove.

However, in keeping with downsizing of electronic apparatuses for use in, e.g., the field of mobile communication, reduction in size has come to be increasingly demanded of a semiconductor device housing package designed for use in such electronic apparatuses. The trend toward miniaturization is now making it difficult to leave the insulating base body exposed without forming a conductor in a region secured for forming a dividing groove.

With this being the situation, the following method can be considered: with the dividing groove-forming region covered with a metal layer serving as a conductor, the location of a demarcation line is irradiated with laser light.

Further, Patent Literature 2 (cf. the preamble of the independent claims) aims to provide a chip resistor which improves the dimensional accuracy of a chip by minimizing the protrusion of plating after forming an electrode plating layer, and enabling a divided surface of the chip to absorb the protrusion of plating. According to Patent Literature 2, the solution to this object is: two or more pairs of electrodes are formed on a sheet-like insulating substrate, a plurality of resistors connected to the two or more pairs of electrodes are formed on the insulating substrate, and a protective film for covering the resistors is formed thereon. The insulating substrate is divided along dividing grooves and formed longitudinally and laterally on the insulating substrate, to constitute the cut grooves into chips. Plating layers are formed on electrodes at both ends. The dividing grooves are tapered, and an electrode material and a protective film material are removed in the dividing grooves.

### Citation List

### Patent Literature

Patent Literature 1: Japanese Unexamined Patent Publication JP-A 6-87085 (1994)
Patent Literature 2: Document JP 2005 317927 A

### Summary of Invention

### Technical Problem

However, when a laser of wavelengths in the infrared region, which is commonly used for the formation of dividing grooves, is actuated at a power output level high enough for the formation of dividing grooves, the surface of a plating film lying around the location of a dividing groove may be burned by the heat evolved by the laser with consequent changes in the surface condition of the plating film. This results in a decrease in the strength of adhesion between the plating film and a brazing material.

The invention has been devised in view of the circumstances as mentioned supra, and accordingly an object of the invention is to provide a segmentable wiring board having metal plating film-coated conductors and dividing grooves formed therein with high accuracy and a method for producing the segmentable wiring board, as well as to provide a wiring substrate and a method for producing the wiring substrate.

### Solution to Problem

The invention provides a wiring board, a wiring substrate and a method according to claims 1, 6 and 8. Further embodiments of the invention are described in the dependent claims.

According to an embodiment of the invention, there is provided a segmentable wiring board including a ceramic base body, a conductor, and a glass layer, the glass layer having an upwardly-protruding convexity having a height of 4.5 µm to 32 µm located on the conductor. The ceramic base body has a plurality of wiring substrate regions and dividing grooves located in boundaries among the plurality of wiring substrate regions. Moreover, the conductor is located in a periphery of each of the plurality of wiring substrate regions. Further, the glass layer coveringly extends from an inner surface of each of the dividing grooves of the ceramic base body to a metal plating film.

According to an embodiment of the invention, there is provided a wiring substrate including a ceramic base body, a conductor, and a glass layer, the glass layer having an upwardly-protruding convexity having a height of 4.5 µm to 32 µm located on the conductor. The conductor is located in a periphery of a first main surface of the ceramic base body. Moreover, the glass layer covers a side surface of the ceramic base body and a side surface of the conductor.

According to an embodiment of the invention, there is provided a method for producing a segmentable wiring board including a step of forming a composite body including a ceramic base body and a conductor and a step of forming dividing grooves and a glass layer. The composite body includes a ceramic base body having a plurality of wiring substrate regions and a conductor located in a periphery of each of the plurality of wiring substrate regions. Moreover, the dividing grooves are formed in the ceramic base body by applying laser light of wavelengths in the ultraviolet region penetratingly to the conductor. Further, the glass layer is so formed as to cover the inner surface of each of the dividing grooves of the ceramic base body and a side surface of the conductor, the glass layer having an upwardly-protruding convexity located on the conductor, the upwardly-protruding convexity having a height of 4.5 µm to 32 µm.

There is provided a method for producing a wiring substrate including a step of dividing a segmentable wiring board constructed by the above-described method for producing a segmentable wiring board, along the dividing grooves into a plurality of wiring substrates.

### Advantageous effects of Invention

According to the segmentable wiring board pursuant to the invention, the glass layer has an upwardly-protruding convexity located on the conductor. Accordingly, at the time of attaching a metal-made lid body and frame body to the periphery, it is possible to suppress the flow of a brazing material for use into the dividing groove by the convexity.

### Brief Description of Drawings

Fig. 1 is an explanatory diagram of an example of a method for producing a segmentable wiring board according to the invention, illustrating a segmentable wiring board yet to be subjected to irradiation of laser light;
Fig. 2 is an explanatory diagram of the segmentable wiring board shown in Fig. 1 in the state of being radiated with laser light;
Fig. 3 is an explanatory diagram of the segmentable wiring board shown in Fig. 1 as seen after the irradiation of laser light, wherein Fig. 3(a) is a schematic plan view showing part of the segmentable wiring board, and Fig. 3(b) is an enlarged sectional view of a main part of the segmentable wiring board;
Fig. 4 is a perspective view of a semiconductor device housing package employing a wiring substrate obtained by dividing an example of the segmentable wiring board of the invention;
Fig. 5 is an enlarged sectional view of a main part of the segmentable wiring board shown in Fig. 1, illustrating a state where a dividing groove is additionally formed in the bottom surface of the segmentable wiring board;
Fig. 6 is an enlarged sectional view of a main part of an example of the segmentable wiring board according to the invention, illustrating a state where a brazing material is applied on to a metal plating film;
Fig. 7(a) is a perspective view of an example of the wiring substrate of the invention, and Fig. 7(b) is a sectional view taken along the line A-A shown in Fig. 7(a); and
Fig. 8 is an enlarged sectional view of an example of the wiring substrate according to the invention.

### Description of Embodiments

Hereinafter, an embodiment of the invention will be described with reference to the accompanying drawings.

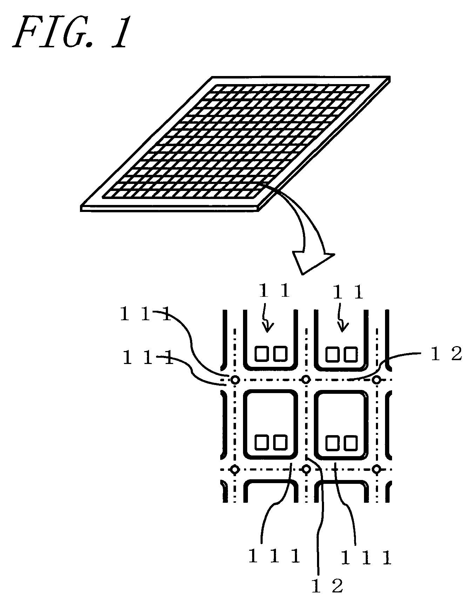

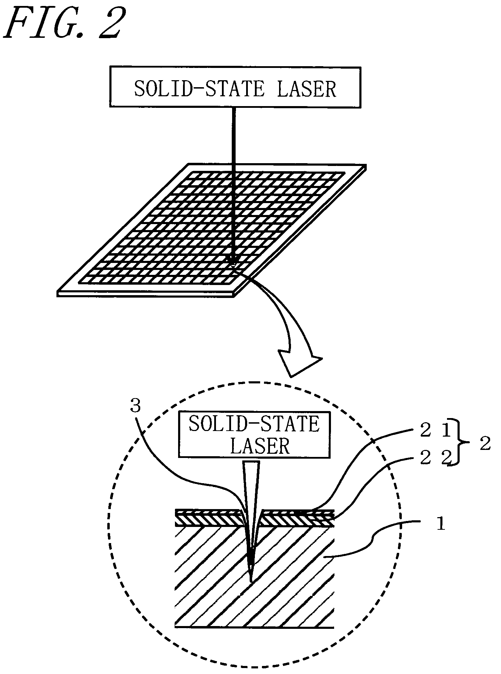

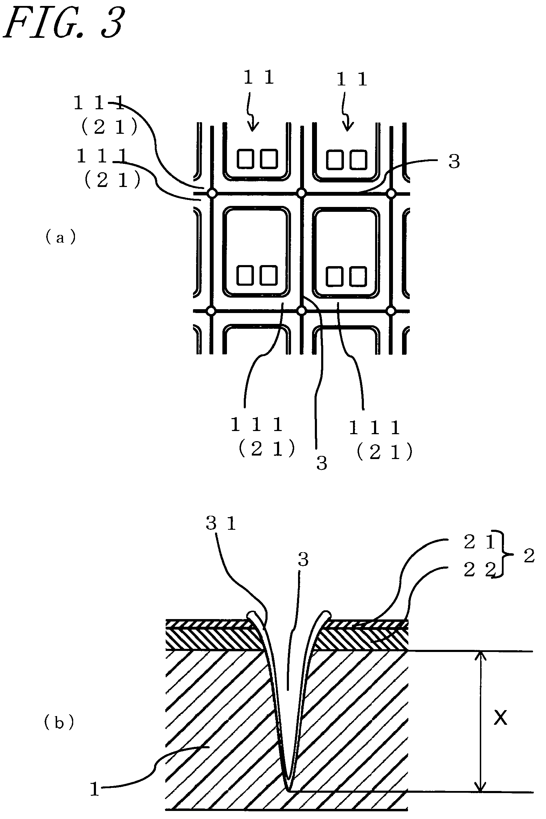

Fig. 1 is an explanatory diagram of a method for producing a segmentable wiring board in accordance with one embodiment of the invention, illustrating the segmentable wiring board yet to be subjected to irradiation of laser light. Moreover, Fig. 2 is an explanatory diagram of the segmentable wiring board shown in Fig. 1 in the state of being radiated with laser light. Further, Fig. 3 is an explanatory diagram of the segmentable wiring board shown in Fig. 1 as seen after the irradiation of laser light, wherein Fig. 3(a) is a schematic plan view showing part of the segmentable wiring board, and Fig. 3(b) is an enlarged sectional view of the main part of the segmentable wiring board.

As exemplified in Figs. 1 to 3, the segmentable wiring board according to one embodiment of the invention includes a ceramic base body 1 having a plurality of wiring substrate regions 11 and dividing grooves 3 each disposed along a demarcation line 12 between the plurality of wiring substrate regions 11; a conductor 2 composed of a conductor metallization layer 22 and a metal plating film 21 disposed on the metallization layer 22 located in a periphery 111 of each of the plurality of wiring substrate regions 11; and a glass layer 31 coveringly extending from the inner surface of the dividing groove 3 of the ceramic base body 1 to the metal plating film 21. The glass layer 31 has a convexity 311 protruding upward on the metal plating film 21.

The ceramic base body 1 is formed of a stack of a plurality of e.g., 50 to 200 µm-thick ceramic insulating layers, each of which is made of a sintered body composed predominantly of alumina, silicon nitride, aluminum nitride, silicon carbide, mullite, ferrite, glass ceramic, or the like. For example, the thickness of the ceramic base body 1 falls in a range of 50 µm to 200 µm. Moreover, the ceramic base body 1 can contain at least one of metal oxides selected from a group consisting of Mg, Mn, Co, Cr, Cu, Ni, and Fe as a component for increasing the rate of laser light absorption. For example, in the case of forming the ceramic base body 1 of a sintered body composed predominantly of alumina, it is advisable to use a material containing Al₂O₃ as a major constituent in an amount of 92% by mass, and, as sintering aids, SiO₂ in an amount of 3% by mass, Mn₂O₃ in an amount of 3.5% by mass, MgO in an amount of 1% by mass, and MoO₃ in an amount of 0.5% by mass; a material containing Al₂O₃ as a major constituent in an amount of 90.5% by mass, and, as sintering aids, SiO₂ in an amount of 1.5% by mass, Mn₂O₃ in an amount of 2.5% by mass, MgO in an amount of 1% by mass, TiO₂ in an amount of 1% by mass, and CrO in an amount of 3.5% by mass; a material containing Al₂O₃ as a major constituent in an amount of 93% by mass, and, as sintering aids, SiO₂ in an amount of 2% by mass, Mn₂O₃ in an amount of 3% by mass, MgO in an amount of 1% by mass, and M₀O₃ in an amount of 1% by mass; or the like.

The wiring substrate regions 11 are each e.g., 0.5 mm to 20 mm on a side. As shown in Fig. 1, the periphery 111 of each of the wiring substrate regions 11 is contiguous to the demarcation line 12.

As shown in Figs. 2 and 3, the dividing groove 3 is formed in the shape of the letter V along the demarcation line 12 between the plurality of wiring substrate regions 11 disposed on the top surface of the ceramic base body 1. Moreover, in the periphery 111 of each of the wiring substrate regions 11 contiguous to the dividing groove 3 is formed the conductor 2 made of the metallization layer 22 covered with the metal plating film 21 having an annular shape as planarly viewed.

As will hereafter be described, the V-shaped dividing groove 3 is formed by applying laser light of wavelengths in, e.g., the ultraviolet region from above the metallization layer 22 covered with the metal plating film 21, so that the laser light penetrates the metal plating film 21 and the metallization layer 22. More specifically, under the condition where the metallization layer 22 covered with the metal plating film 21 lies on the demarcation line 12 between the plurality of wiring substrate regions 11 as well as in the periphery 111 of each of the wiring substrate regions 11 contiguous to the demarcation line 12 on the top surface of the ceramic base body 1, laser light of wavelengths in, e.g., the ultraviolet region is applied from above the metal plating film 21 on the demarcation line 12, so that the laser light penetrates the metal plating film 21 and the metallization layer 22.

The metallization layer 22 is obtained by firing a conductor paste composed predominantly of W, Mo, Cu, Ag, Pt, or the like. At this time, an appropriate conductor which is firable simultaneously with the ceramic base body 1 is selected for use. Note that, just like the ceramic base body 1, the metallization layer 22 can contain at least one of metal oxides selected from a group consisting of Mg, Mn, Co, Cr, Cu, Ni, and Fe as a component for increasing the rate of laser light absorption.

Moreover, the metal plating film 21 covering the metallization layer 22 is provided to suppress oxidative corrosion of the metallization layer 22, as well as to achieve enhancement in wettability and adhesion strength during brazing or the like process. The metal plating film 21 preferably has a double-layer structure composed of e.g., a Ni-made plating layer formed as a lower layer and a Au-made plating layer formed as an upper layer. In this case, from a cost standpoint, the metal plating film 21 is preferably has a small thickness, wherefore the Ni plating layer has a thickness in a range of ca. 2 µm to 10 µm and the Au plating layer has a thickness in a range of ca. 0.2 µm to 1.5 µm. For example, the metal plating film 21 can be formed by feeding an electric current for plating to the to-be-plated part (the surface of the metallization layer 22) in a plating solution to effect electrolytic plating.

It is noted that the sum of the thicknesses of the metallization layer 22 and the metal plating film 21 (the thickness of the conductor 2) is adjusted to fall in a range of 20 µm to 80 µm in the interest of formation of the glass layer 31 which will hereafter be described.

The metallization layer 22 covered with the metal plating film 21 formed in the periphery 111 of each of the wiring substrate regions 11 is provided in the interest of adhesion of a lid body or a frame body (not shown) by means of brazing or otherwise.

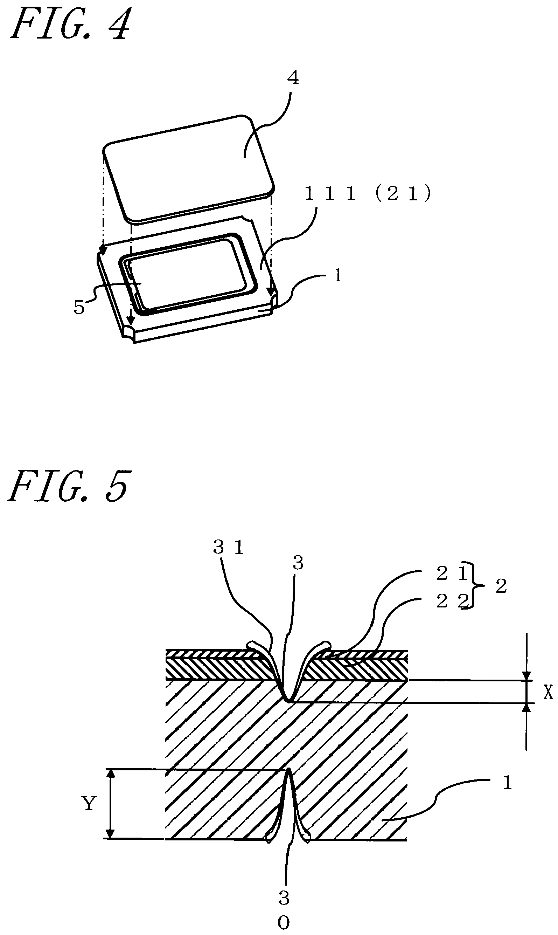

That is, each of the wiring substrate regions 11 becomes one constituent component of a semiconductor device housing package, for example. More specifically, as shown in Fig. 4, in each of the wiring substrate regions 11 of the ceramic base body 1, a recess is formed inside the periphery 111 for placement of a semiconductor device 5, and a metal-made lid body 4 is attached onto the metallization layer 22 covered with the metal plating film 21 formed in the periphery 111. In this way, the semiconductor device housing package can be fabricated. Alternatively, although not shown in the figures, the semiconductor device housing package can be fabricated as follows. In each of the wiring substrate regions 11 of the ceramic base body 1, instead of forming a recess inside the periphery 111 for placement of a semiconductor device 5, a metal-made frame body (not shown) is attached onto the metallization layer 22 covered with the metal plating film 21 formed in the periphery 111, and the lid body 4 is attached to the top surface of the frame body. The metallization layer 22 covered with the metal plating film 21 formed in the periphery 111 of each of the wiring substrate regions 11 is provided in the interest of adhesion of such a lid body 4 or frame body (not shown) by means of brazing or otherwise.

The glass layer 31 covers the inner surface of the dividing groove 3. As will hereafter be described, the glass layer 31 is composed predominantly of a coating which adhered to the inner surface of the dividing groove 3 as the result of volatilization of a glass component contained in the ceramic base body 1 under the irradiation of laser light of wavelengths in the ultraviolet region. Moreover, such a glass layer 31 extends from the inner surface of the dividing groove 3 (the ceramic base body 1) to the metal plating film 21, and has a thickness in a range of ca. 0.5 µm to 15 µm. For example, in the case where the ceramic base body 1 is made of a material containing Al₂O₃ as a major constituent in an amount of 92% by mass, and, as sintering aids for example, SiO₂ in an amount of 3% by mass, Mn₂O₃ in an amount of 3.5% by mass, MgO in an amount of 1% by mass, and M₀O₃ in an amount of 0.5% by mass, then the glass layer 31 is designed as an amorphous layer containing Al, Si, Mn, Mg, Mo, and so forth. That is, where the ceramic base body 1 is made of a sintered body composed predominantly of alumina as above described, the glass layer 31, while containing a high proportion of components derived from e.g., sintering aids (Si, Mn, Mg, Mo), contains additionally an alumina-derived component (Al) and also constituent components of the metallization layer 22 and the metal plating film 21. Note that the dividing groove 3 has its inner surface covered with the glass layer 31 and is nevertheless V-shaped in section. Therefore, the dividing groove 3 serves the purpose of dividing the segmentable wiring board satisfactorily.

The glass layer 31, containing the same glass component as contained in the ceramic base body 1 as above described, is capable of enhancing the strength of adhesion between the glass layer 31 and the ceramic base body 1.

The thickness of the glass layer 31 varies depending on the sum of the thicknesses of the metallization layer 22 and the metal plating film 21. The larger the sum of the thicknesses is, the larger the thickness of the glass layer 31 is. This is because the metallization layer 22 and the metal plating film 21 are higher in laser light reflectivity than the ceramic base body 1, wherefore an extra thermal load is developed during the process of forming the dividing groove 3 in a predetermined depth, thereby facilitating precipitation of the glass layer 31 from the ceramic base body 1. By adjusting the sum of the thicknesses of the metallization layer 22 and the metal plating film 21 to fall in a range of 20 µm to 80 µm, it is possible to form the glass layer 31 having a thickness in a range of 0.5 µm to 15 µm. If the thickness of the glass layer 31 in a given section is less than 0.5 µm, the glass layer 31 may not be created in a different section or other part with the consequent exposure of the side surface of the metallization layer 22 in part. This results in the possibility that the metallization layer 22 cannot be protected against corrosion. On the other hand, if the thickness of the glass layer 31 in a given section is greater than 15 µm, the glass layer 31 becomes so thick that a part having no V-shaped dividing groove may arise. This results in the possibility that the dividing groove fails to serve the purpose. Note that the thickness of the glass layer 31 is preferably less than or equal to 10 µm from the standpoint of ease of splitting of the dividing groove 3. Moreover, the angle formed by the lines defining the V-shaped profile of the dividing groove 3 falls in a range of ca. 5 degrees to 15 degrees, and the width of the dividing groove 3 (the width of the opening of the dividing groove 3 as viewed in section) falls in a range of ca. 5 µm to 50 µm.

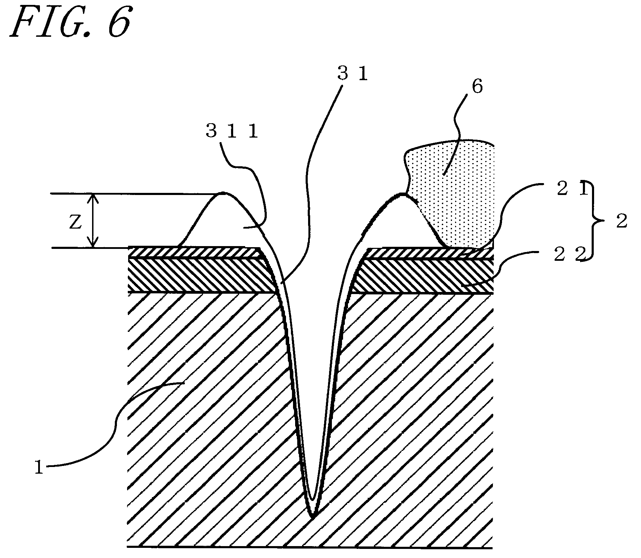

As shown in Fig. 6, the glass layer 31 has the convexity 311 protruding upward on the conductor 2. The height of the convexity 311 falls in a range of 4.5 µm to 32 µm. Moreover, the convexity 311 surrounds each of the wiring substrate regions 11 while being contiguous to the periphery 111 and the dividing groove 3 when planarly viewed.

As shown in Fig. 4, a brazing material is used to attach the metal-made lid body 4, as well as to attach the frame body (not shown) on to the metallization layer 22 covered with the metal plating film 21. At this time, as shown in Fig. 6, by virtue of the convexity 311, the flow of the brazing material 6 into the dividing groove 3 is suppressed. While the effect of controlling the flow of the brazing material 6 can be obtained in so far as the height of the convexity 311 is greater than or equal to 0.1 µm for example, by setting the height to 4.5 µm or more in particular, even in the case of performing reflow process under pressure, it is possible to suppress the flow of the brazing material 6 into the dividing groove 3 fully effectively. Meanwhile, if the convexity 311 has a height of greater than 32 µm, due to application of heat in an amount large enough for the attainment of such a height, for example, the metal plating layer may be burned with the consequent impairment in appearance, or a decrease in bonding strength may occur due to the presence of the convexity 311.

It is preferable to configure the convexity 311 in such a way that its height is greater than the width of its section taken along a direction substantially perpendicular to the dividing groove 3 in contiguous relation therewith when planarly viewed. Such a configuration is effective in suppressing the flow of the brazing material into the dividing groove 3 while reducing the area required for the formation of the convexity 311 of the wiring substrate region 11 when planarly viewed.

By making adjustment to the thicknesses of the metallization layer 22 and the metal plating film 21 as above described, as well as to e.g., the pulse frequency of laser light from a solid-state laser of wavelengths in, e.g., the ultraviolet region as will hereafter be described, it is possible to form the convexity 311 together with the glass layer 31 at one time. The height of the convexity 311 can be measured by means of an atomic force microscope, a surface roughness meter, a laser microscope, or otherwise.

It is noted that the convexity 311, while containing a high proportion of components derived from e.g., sintering aids (Si, Mn, Mg, Mo), contains additionally an alumina-derived component (Al) and also components derived from the metallization layer 22 and the metal plating film 21.

With use of the segmentable wiring board having the convexity 311 extending the glass layer 31 to part of the top surface of the metal plating film 21 as above described, it is possible to produce a segmentable electronic component in which a recess is formed in that part of the ceramic base body located inside the conductor of each of the wiring substrate regions of the segmentable wiring board, the recess of each of the wiring substrate regions accommodating a semiconductor device, and the lid body is attached, through the brazing material, to the top surface of the metal plating film for covering the conductor. Accordingly, there is obtained a segmentable electronic component in which the brazing material is restrained from flowing into the dividing groove.

In a case where the conductor 2 is situated under the convexity 311 of the glass layer 31 and upwardly protrudes, a metal projection is embedded in the metal plating film 21 side of the convexity 311. In this case, the convexity 311 is reinforced by the protrusion of the conductor 2. This is effective in suppressing damage to the convexity 311 when it is subjected to a lateral force.

With such a protrusion of the conductor 2 left exposed at a midportion of the wiring substrate region 11, when the lid body 4 is bonded to the metallization layer 22 by a brazing material, it is possible to achieve firm bonding in the region of contact between the conductor 2 and the brazing material. This is therefore effective in enhancing the bonding strength. Note that the convexity 311 placed on the protrusion of the conductor 2 is made of a glass layer and therefore exhibits poor wettability to the brazing material. This makes it possible to suppress that the brazing material flows over the convexity 311 into the dividing groove 3.

Meanwhile, the dividing groove 3 formed in the top surface of the ceramic base body 1 may be configured to have a depth in a range of 5 µm to 16 µm. By adjusting the depth of the dividing groove 3 to fall in a range of 5 µm to 16 µm, it is possible to obtain a segmentable wiring board in which adhesion of machining chips to the surface of the metal plating film 21 can be suppressed.

As used herein, the term "the depth of the dividing groove 3" refers to a distance from the top surface of the ceramic base body 1 (the interface between the ceramic base body 1 and the metallization layer 22) to the lowermost point (the interface between the ceramic base body 1 and the glass layer 31), namely a distance X indicated in Fig. 3(b).

The reason for setting the depth of the dividing groove 3 to be greater than or equal to 5 µm is to ensure that the inner surface of the dividing groove 3 is evenly covered with the glass layer 31. If the depth is less than 5 µm, part of the inner surface will not be covered with the glass layer 31 completely. On the other hand, the reason why the depth of the dividing groove 3 is set to be less than or equal to 16 µm is that, the larger the depth of the dividing groove 3 is, the larger the width of the dividing groove 3 (the width of the opening of the dividing groove as viewed in section) is. Therefore, if the depth of the dividing groove 3 is greater than 16 µm, machining chips (molten matters) resulting from the heat evolved by the irradiation of laser light will be volatilized and scattered outwardly of the dividing groove 3 without being caught in the inside of the dividing groove 3, and eventually adhere to the surface of the metal plating film 21.

In the case of forming the dividing groove 3 in a relatively shallow depth in the top surface of the ceramic base body 1, in the interest of ease of splitting, as shown in Fig. 5, it is preferable to form a V-shaped dividing groove 30 in the bottom surface of the ceramic base body 1 in face-to-face relation with the dividing groove 3 formed in the top surface of the ceramic base body 1.

By forming the dividing groove 30 in the bottom surface of the ceramic base body 1 in face-to-face relation with the dividing groove 3 formed in the top surface of the ceramic base body 1, at the time of division of the substrate into the wiring substrate regions 11, it is possible to suppress more reliably imperfections such as burrs, chipping or hollowness that are likely to occur in the side surface of the wiring substrate segment.

Although it depends on the thickness and strength of the ceramic base body 1, it is preferable that the sum of the depths of the dividing groove 3 formed in the top surface of the ceramic base body 1 and the dividing groove 30 formed in the bottom surface of the ceramic base body 1 (the sum of the distance X and the distance Y shown in Fig. 5) is equal to 30% to 62% of the thickness of the ceramic base body 1. If the sum of the depths of the dividing groove 3 formed in the top surface of the ceramic base body 1 and the dividing groove 30 formed in the bottom surface of the ceramic base body 1 is less than 30% of the thickness of the ceramic base body 1, imperfections such as burrs, chipping or hollowness are likely to occur. On the other hand, if the sum of the depths is greater than 62% of the thickness of the ceramic base body, in a process step subsequent to the laser machining operation, the substrate may be spontaneously divided even under a minor impact or stress. This results in the possibility that the desired segments cannot be obtained.

As described heretofore, the dividing groove 3 lying in the top surface of the ceramic base body 1 is so formed as to pass through the metal plating film 21 and the metallization layer 22; that is, it is not formed in advance so as to extend along the demarcation line 12 between the plurality of wiring substrate regions 11, with the ceramic base body 1 left exposed. This makes it possible to realize a segmentable wiring board in which the metallization layer 22 covered with the metal plating film 21 and the dividing groove 3 are formed with high accuracy.

Moreover, according to the segmentable wiring board pursuant to the invention, the inner surface of the dividing groove 3 is covered with the glass layer 31 extending from the ceramic base body 1 to the metal plating film 21. This makes it possible to suppress oxidative corrosion of the side surface of the metallization layer 22 facing the dividing groove 3.

Upon breaking up the above-described segmentable wiring board along the dividing grooves 3, the segmentable wiring board is divided into the plurality of wiring substrate regions 11, thereby obtaining separate wiring substrates. In the segmentable wiring board of the invention, since the inner surface of the dividing groove 3 is covered with the glass layer 31 extending from the ceramic base body 1 to the metal plating film 21, it follows that the wiring substrates, which are obtained by dividing the segmentable wiring board along the dividing grooves 3 into the plurality of wiring substrate regions 11, are capable of suppressing oxidative corrosion of the side surface of the metallization layer 22 facing the dividing groove 3.

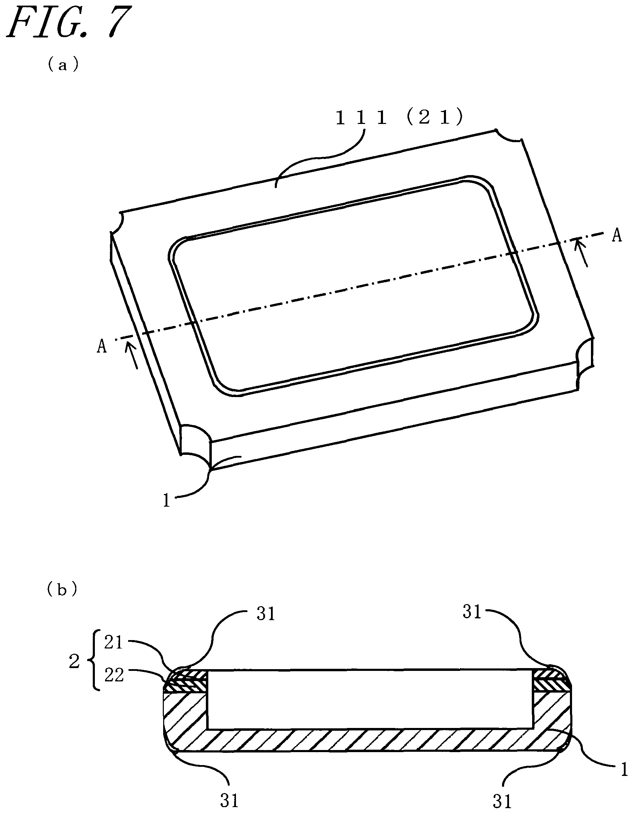

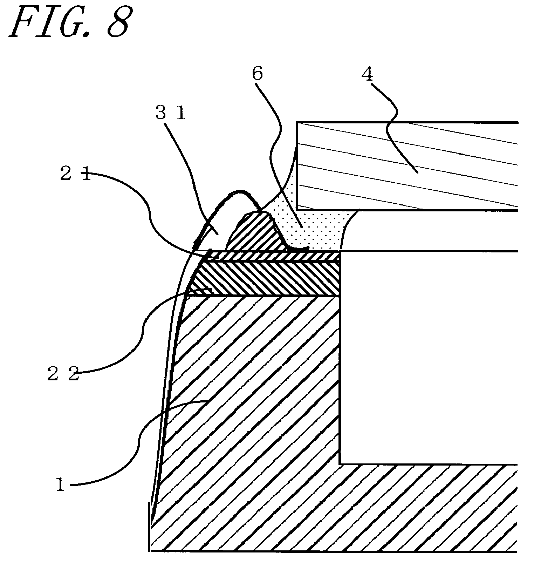

As exemplified in Fig. 7, the wiring substrate of the invention includes the ceramic base body 1; the metallization layer 22 disposed in the periphery 111 of the first main surface of the ceramic base body 1; the metal plating film 21 formed on the metallization layer 22; and the glass layer 31 covering the side surface of the ceramic base body 1 and the side surface of the metallization layer 22, the glass layer 31 having the upwardly-protruding convexity 311 located on the metal plating film 21. In this construction, it is possible to suppress oxidative corrosion of the laterally-facing side surface of the metallization layer 22. Moreover, as shown in Fig. 8, at the time of attaching the metal-made lid body as well as the frame body on to the metallization layer 22, by virtue of the convexity 311, it is possible to suppress the flow of the brazing material for use to the side surface of the wiring substrate.

Moreover, in the wiring substrate, where the conductor 2 is situated under the convexity 311 of the glass layer 31 and upwardly protrudes, the convexity 311 is reinforced by the protrusion of the conductor 2. This is effective in suppressing damage to the convexity 311 when it is subjected to a lateral force.

Next, methods for producing the segmentable wiring board and the wiring substrate thus far described will be explained below.

To begin with, the ceramic base body 1 having a plurality of wiring substrate regions 11 is fabricated, and also the metallization layer 22 is formed so as to cover the demarcation line 12 between the plurality of wiring substrate regions 11 and the periphery 111 of each of the wiring substrate regions 11 adjacent to the demarcation line 12 on the top surface of the ceramic base body 1.

Powder of raw materials such as alumina, silicon nitride, aluminum nitride, silicon carbide, mullite, ferrite or glass ceramics is kneaded with an organic solvent and a binder. The resultant kneaded body is shaped into sheet-like products, thereby preparing a plurality of ceramic green sheets. The thickness of the ceramic green sheet is determined in a manner such that the thickness of a ceramic insulating layer obtained after the firing of the ceramic green sheets falls in a range of 50 µm to 200 µm, for example.

Next, a through hole is formed in the ceramic green sheet, and a conductor paste for through conductor is charged into the through hole to obtain a through conductor. Then, a conductor paste for wiring layer is applied so as to be deposited on one main surface of the ceramic green sheet to obtain a wiring layer. Moreover, a conductor paste for conductor is applied so as to be deposited on one main surface of the uppermost ceramic green sheet of a stack of ceramic green sheets to obtain the metallization layer 22. The thickness of the conductor paste for conductor is determined in a manner such that the sum of the thicknesses of the metallization layer 22 and the metal plating film 21 obtained after the firing of the conductor paste falls in a range of 20 µm to 80 µm. For example, given that the sum of the thicknesses is 30 µm and the metal plating film 21 has a thickness of 5 µm, then the thickness of the conductor paste for conductor is adjusted in a manner such that the metallization layer 22 has a thickness of 25 µm.

Moreover, on an as-needed basis, a through hole is formed in several of the plurality of ceramic green sheets to form a recess in the top surface of the ceramic base body 1 for the placement of the semiconductor device 5. Such ceramic green sheets are stacked on top of each other, thereby forming a ceramic green sheet stacked body. The ceramic green sheet stacked body thus obtained is fired in a desired firing atmosphere and at a desired firing temperature. For example, where the conductor paste for through conductor and the conductor paste for wiring layer are each composed predominantly of materials of W and Mo and the ceramic green sheet is made of an alumina material, the firing is performed under conditions of a reduction atmosphere and a firing temperature in a range of 1300°C to 1600°C. Moreover, where the conductor paste for through conductor and the conductor paste for wiring layer are each composed predominantly of a material of Cu and the ceramic green sheet is made of a glass ceramic material, the firing is performed under conditions of a reduction atmosphere of nitrogen and a firing temperature in a range of 800° C to 1000°C. Further, where the conductor paste for through conductor and the conductor paste for wiring layer are each composed predominantly of a material of Ag and the ceramic green sheet is made of a glass ceramic material, the firing is performed under conditions of an air atmosphere and a firing temperature in a range of 800°C to 1000°C.

While, for the sake of convenience, the ceramic base body 1 is regarded as including the wiring layer obtained by sintering the conductor paste for wiring layer and the through conductor obtained by sintering the conductor paste for through conductor, in reality the ceramic base body 1 can either include them or include none of them.

Moreover, in the process of forming the metallization layer 22 so as to cover the demarcation line 12 between the plurality of wiring substrate regions 11 and the periphery 111 of each of the wiring substrate regions 11 adjacent to the demarcation line 12 on the top surface of the ceramic base body 1, as is the case with the conductor paste for wiring layer as above described, it is preferable that a conductor paste for forming the metallization layer 22 is applied so as to be deposited on one main surface of the ceramic green sheet, and the conductor paste is fired together with the ceramic green sheet at one time.

Next, the metal plating film 21 is coveringly formed on the metallization layer 22. For example, the metal plating film 21 is formed by feeding an electric current for plating to the to-be-plated part (the surface of the metallization layer 22) in a plating solution to effect electrolytic plating. The metal plating film 21 is preferably designed to have a double-layer structure consisting of a Ni plating layer formed as a lower layer and a Au plating layer formed as an upper layer.

Next, the dividing groove 3 is formed along the demarcation line 12 between the plurality of wiring substrate regions 11 through the irradiation of laser light from a solid-state laser of wavelengths in, e.g., the ultraviolet region (YAG laser, for example). Moreover, the glass layer 31 is formed on the inner surface of the dividing groove 3 so as to extend from the ceramic base body 1 to the metal plating film 21.

The laser light of wavelengths in the ultraviolet region used for laser irradiation ranges from 10 kHz to 200 kHz in respect of pulse frequency specific to the solid-state laser; is greater than or equal to 5 ns in respect of pulse width; and ranges from 1 W to 100 W, preferably ca. from 1 W to 40 W, in respect of power output at a processed point. Examples of the solid-state laser of wavelengths in the ultraviolet region include lasers employing crystal such as YAG, YVO₄, and YLF for lasing, and it is possible to choose the one that best suited to serving the purpose with consideration given to the pulse characteristics thereof and the workability of workpiece materials. From the standpoint of the time taken for the dividing groove 3-forming process, it is particularly preferable to use a YAG laser operating at the third harmonic (wavelength: 355 nm) which ranges from 10 kHz to 100 kHz in respect of pulse frequency; ranges from 50 ns to 200 ns in respect of pulse width; and ranges from ca. 1 W to 30 W in respect of power output at a processed point.

In the case where the solid-state laser is a YAG laser, laser light of the fundamental or the second harmonic exhibits high reflectance to the metal plating film 21, and therefore does not lend itself to the formation of a V-shaped groove which serves as the dividing groove 3. Meanwhile, laser light of a wavelength of 10.6 µm from a carbon dioxide laser exerts a considerable thermal influence on the ceramic base body 1. In this case, the groove is inconveniently filled with a molten part of the ceramic base body 1 (glass layer 31), wherefore the dividing groove 3 cannot practically be formed.

In contrast, laser light of wavelengths in the ultraviolet region exhibits high absorbance and low reflectance to the metal plating film 21, and also exhibits high absorbance to the ceramic base body 1 and therefore exerts little thermal influence thereon. Accordingly, even if this laser light is applied from above the metal plating film 21 covering the metallization layer 22, the V-shaped dividing groove 3 can be formed. That is, it is possible to obtain a segmentable wiring board in which the metallization layer 22 covered with the metal plating film 21 and the dividing groove 3 are formed with high accuracy.

Moreover, it is important to ensure that the glass layer 31 is formed on the inner surface of the dividing groove 3 so as to extend from the ceramic base body 1 to the metal plating film 21. In other words, it is important to ensure that the glass layer 31 is formed on the inner surface of the dividing groove 3 so as to extend from the ceramic base body 1 to the metal plating film 21 during the formation of the dividing groove 3.

The glass layer 31 is formed by causing the evaporated components of the ceramic base body 1, the metallization layer 22, and the metal plating film 21 resulting from the irradiation of laser light of wavelengths in the ultraviolet region to adhere to the inner surface of the dividing groove 3 so as to extend from the ceramic base body 1 to the metal plating film 21. An advantage of the use of such a laser light of wavelengths in the ultraviolet region is that the dividing groove can be formed by means of abrasion machining with little thermal influence on the ceramic base body 1. Note that, by making changes to the pulse frequency of laser light, variation in pulse energy occurs, which results in changes in the condition of heat application. Therefore, the thickness of the glass layer 31 can be adjusted also by pulse frequency control.

By forming the glass layer 31 on the inner surface of the dividing groove 3 so as to extend from the ceramic base body 1 to the metal plating film 21, it is possible to cover the side surface of the metallization layer 22 left exposed due to solid-state laser irradiation with the glass layer 31, and thereby suppress oxidative corrosion of the side surface of the metallization layer 22.

In addition to the glass layer 31, the convexity 311 is preferably formed by extending the glass layer 31 to part of the top surface of the metal plating film 21. The convexity 311 can be formed simultaneously with the glass layer 31 in so far as the thicknesses of the metallization layer 22 and the metal plating film 21, the pulse frequency of laser light from a solid-state laser having wavelengths in the ultraviolet region, and so forth are adjusted properly.

Once machining chips generated during the formation of the dividing groove 3 by a solid-state laser adhere and become fused to the surface of the metal plating film 21, the machining chips cannot be removed with ease. Furthermore, if the machining chips adhere to the surface of the metal plating film 21, when the lid body 4 is sealingly attached with use of a brazing material or the like, the sealing capability may be impaired. With this being the situation, in order to prevent fusing-adhesion of machining chips, it is advisable to form an easily-rinsable organic protective film (polyvinyl alcohol, for example) on the surface of the metal plating film 21. In this case, following the irradiation of a solid-state laser of wavelengths in the ultraviolet region from above the protective film, machining chips that adhered on the protective film and the protective film altogether are rinsed off.

Moreover, by effecting laser light irradiation while controlling a solid-state laser in a manner such that the depth of the dividing groove falls in a range of 5 µm to 16 µm, it is possible to prevent adhesion of machining chips to the surface of the metal plating film 21 without the necessity of using the protective film. At this time, it is preferable that the V-shaped dividing groove 30 is formed in the bottom surface of the ceramic base body 1 in face-to-face relation with the dividing groove 3 formed in the top surface of the ceramic base body 1, and the sum of the depths of the dividing groove 3 formed in the top surface of the ceramic base body 1 and the dividing groove 30 formed in the bottom surface of the ceramic base body 1 is equal to 30% to 62% of the thickness of the ceramic base body 1. This makes it possible to suppress imperfections such as burrs, chipping or hollowness that are likely to occur in the side surface of the wiring substrate segment during the split of the dividing groove.

It is noted that the bottom surface of the ceramic base body 1 is, just like the top surface, formed with components including the conductor covered with the metal plating film 21 and an electrode pad or lead wire. In the case of applying laser light from above these components, laser light of wavelengths in the ultraviolet region excited by a solid-state laser as will hereafter be described is adopted for use. However, in the case of applying laser light to an exposed part of the ceramic base body, for example, laser light excited by a solid-state laser or laser light from a carbon dioxide laser is adopted for use. Moreover, alignment of the position of the dividing groove 30 in the bottom surface and the position of the dividing groove 3 in the top surface is preferably made with use of e.g., castellation holes that are scattered within the segmentable wiring board. Instead of the castellation holes, it is possible to use alignment marks formed in e.g., the outer frame of the segmentable wiring board or other important locations determined in consideration of shrinking deformation of the ceramic substrate by means of conductor printing, die punching, or otherwise.

According to the producing method thus far described, it is possible to obtain a segmentable wiring board in which the metallization layer 22 covered with the metal plating film 21 and the dividing groove 3 are formed with high accuracy.

A method for producing a wiring substrate includes a process step of dividing the segmentable wiring board produced by the above-described method for producing the segmentable wiring board, along the dividing grooves 3, into a plurality of wiring substrates. Note that, as a method for substrate division, for example, the use of a dividing apparatus based on a so-called three-point bending technique makes it possible to achieve highly accurate substrate division.

In this way, it is possible to obtain a wiring substrate in which oxidative corrosion of the side surface of the metallization layer 22 facing the dividing groove 3 is suppressed.

It should be noted that the invention is not limited to the embodiments and examples as described hereinabove, and therefore various changes and modifications may be made without departing from the gist of the claimed invention.

### Examples

### (Example 1)

Powder of raw materials prepared by blending SiO₂ powder in an amount of 3% by mass, Mn₂O₃ powder in an amount of 3.5% by mass, MgO powder in an amount of 1% by mass, and MoO₃ powder in an amount of 0.5% by mass into Al₂O₃ powder in an amount of 92% by mass was kneaded with an organic solvent and a binder. The resultant kneaded body was shaped into sheet-like products, thereby preparing three 150 µm-thick ceramic green sheets. The ceramic green sheets were stacked on top of each other, thereby preparing a ceramic green sheet stacked body.

Next, a conductor paste composed predominantly of Mo was applied so as to be deposited on the top surface of the ceramic green sheet stacked body. At that time, there were prepared samples coated with the conductor pastes of varying thickness; that is, the thicknesses of the conductor pastes were so determined as to correspond to the values of 28 µm, 34 µm, 41 µm, 53 µm, 59 µm, and 64 µm, respectively, each representing the sum of the thickness of the resultant conductor, the thickness of a subsequently-described Ni plating layer (4 µm), and the thickness of a subsequently-described Au plating layer (0.4 µm) as obtained after firing process.

Next, the samples were fired for 18 hours in a forming-gas atmosphere at a temperature of 1350°C.

Next, as the metal plating film, a Ni plating layer was formed in a thickness of 4 µm and a Au plating layer was formed in a thickness of 0.4 µm. In this way, there were fabricated ceramic substrates having the metal plating film-covered conductor formed on their top surfaces.

Then, laser light was applied to the ceramic substrate thus obtained from above the conductor including the metal plating film for groove-forming machining operation.

It is noted that the irradiation of laser light was effected with use of a 355 nm-wavelength YAG laser-equipped laser scribing apparatus having a placement table which is movable in one axial direction while carrying a workpiece. At that time, the following conditions were established: power output at a processed point stands at 7.4 W under a pulse frequency of 10 kHz, stands at 6.1 W under a pulse frequency of 30 kHz, and stands at 4.9 W under a pulse frequency of 50 kHz.

Under the above three conditions, the groove-forming machining operation was performed on each of the ceramic substrates of varying thickness of the metal plating film-including conductor. The machining speed and the number of passes were adjusted so that the V-shaped groove has a depth of about 70 µm in each and every ceramic substrate.

Subsequently, the ceramic substrate was polished on its side surface in a direction perpendicular to the length of the groove, and then, for example, surface grinding was conducted with use of a cross-section polisher. After that, the section of the V-shaped groove was observed by an electronic microscope to determine the width of the V-shaped groove and the thickness of a glass layer created on the inner surface of the V-shaped groove. In the determination of the thickness of the glass layer, a distance from that part of the V-shaped groove contiguous to the conductor to the surface of the vertical glass layer was derived. This distance was defined as the glass layer thickness.

Moreover, simple measurement of convexity height was conducted by a microscope. Among the measured convexities, the ones that are greater than or equal to 1 µm but less than 3 µm in height were subjected to precise measurement using an atomic force microscope to obtain exact heights, and the ones that are greater than or equal to 3 µm in height were subjected to precise measurement using a laser microscope to obtain exact heights.

The resultant data will be listed on Table 1.

**Table 1**

| Sample No. | Total thickness of conductor and metal plating film (µm) | Output level (W) | Pulse frequency (kHz) | Groove width (µm) | Glass layer thickness (µm) | Convexity height (µm) |
|---|---|---|---|---|---|---|
| 1 | 15 | 4.9 | 50 | 12.3 | 1.6 | 4.4 |
| 2 | 15 | 6.1 | 30 | 10.4 | 0.8 | 2.3 |
| 3 | 15 | 7.4 | 10 | 7.9 | 0.3 | 0.1 |
| 4 | 20 | 4.9 | 50 | 15.5 | 2.1 | 5.2 |
| 5 | 20 | 6.1 | 30 | 14.2 | 1.3 | 3.1 |
| 6 | 20 | 7.4 | 10 | 9.6 | 0.5 | 0.1 |
| 7 | 28 | 4.9 | 50 | 15.4 | 3.7 | 6.7 |
| 8 | 28 | 6.1 | 30 | 14.7 | 1.4 | 4.5 |
| 9 | 28 | 7.4 | 10 | 11.3 | 0.7 | 0.2 |
| 10 | 34 | 4.9 | 50 | 15.2 | 4.2 | 7.4 |
| 11 | 34 | 6.1 | 30 | 14.8 | 1.5 | 4.6 |
| 12 | 34 | 7.4 | 10 | 11.3 | 0.9 | 0.3 |
| 13 | 41 | 4.9 | 50 | 19.7 | 5.1 | 11.8 |
| 14 | 41 | 6.1 | 30 | 16.4 | 2.3 | 5.5 |
| 15 | 41 | 7.4 | 10 | 12.0 | 1.5 | 0.7 |
| 16 | 53 | 4.9 | 50 | 23.5 | 6.2 | 14.2 |
| 17 | 53 | 6.1 | 30 | 19.4 | 3.6 | 7.5 |
| 18 | 53 | 7.4 | 10 | 14.3 | 2.7 | 1.3 |
| 19 | 59 | 4.9 | 50 | 28.2 | 7.9 | 18.1 |
| 20 | 59 | 6.1 | 30 | 24.1 | 4.4 | 10.2 |
| 21 | 59 | 7.4 | 10 | 15.9 | 3.6 | 1.6 |
| 22 | 64 | 4.9 | 50 | 32.8 | 9.8 | 22.4 |
| 23 | 64 | 6.1 | 30 | 28.3 | 6.3 | 12.8 |
| 24 | 64 | 7.4 | 10 | 17.4 | 4.3 | 2.2 |
| 25 | 80 | 4.9 | 50 | 33.2 | 15 | 32 |
| 26 | 80 | 6.1 | 30 | 28.7 | 10 | 14.9 |
| 27 | 80 | 7.4 | 10 | 18.4 | 6.7 | 3.3 |
| 28 | 90 | 4.9 | 50 | 37.9 | 18.4 | 35 |
| 29 | 90 | 6.1 | 30 | 31.1 | 15.7 | 19.8 |
| 30 | 90 | 7.4 | 10 | 21.3 | 10.6 | 5.6 |

It is apparent from Table 1 that the invention makes it possible to obtain the segmentable wiring board in which the inner surface of the dividing groove is covered with the ca. 0.5 to 15 µm-thick glass layer extending from the ceramic base body to the metal plating film.

Moreover, it has been found that, in the samples that are less than 20 µm in the sum of the thicknesses of the conductor and the metal plating film, depending on output level and pulse frequency, the thickness of the glass layer in a given measured section is less than 0.5 µm. It has also been found that, in the sample having such a glass-layer part with a thickness of less than 0.5 µm, the conductor is exposed in part of the inner surface of the dividing groove, wherefore the glass layer fails to suppress oxidative corrosion of the conductor satisfactorily.

Furthermore, it has been found that, in the samples that are greater than 80 µm in the sum of the thicknesses of the conductor and the metal plating film, depending on output level and pulse frequency, the thickness of the glass layer in a given measured section exceeds 15.0 µm. It has also been found that, in the sample having such a glass-layer part with a thickness of greater than 15.0 µm, the dividing groove is filled with the glass layer and is not V-shaped, and therefore fails to serve the purpose.

It has also been confirmed that, in addition to the glass layer, the convexity was formed as the extension of the glass layer lying over part of the top surface of the metal plating film. In addition, where Sample Nos. 3, 7 through 15, and 22 through 27 are concerned, a brazing material was applied on to the conductor covered with the metal plating film, and on the brazing material was mounted a lid body. Then, following the completion of reflow process, the interior of the dividing groove was examined by an optical microscope using a lens of a magnification of 20 times. The result of examination showed that the flow of the brazing material into the dividing groove was suppressed in each and every sample.

### (Example 2)

Powder of raw materials prepared by blending SiO₂ powder in an amount of 3% by mass, Mn₂O₃ powder in an amount of 3.5% by mass, MgO powder in an amount of 1% by mass, and MoO₃ powder in an amount of 0.5% by mass into Al₂O₃ powder in an amount of 92% by mass was kneaded with an organic solvent and a binder. The resultant kneaded body was shaped into sheet-like products, thereby preparing three 150 µm-thick ceramic green sheets. The ceramic green sheets were stacked on top of each other, thereby preparing a ceramic green sheet stacked body.

Next, a conductor paste composed predominantly of Mo was applied so as to be deposited on the top surface of the ceramic green sheet stacked body. At that time, there were prepared samples each coated with the conductor paste whose thickness was so determined that the sum of the thickness of the resultant conductor, the thickness of a subsequently-described Ni plating layer (4 µm), and the thickness of a subsequently-described Au plating layer (0.4 µm) as obtained after firing process takes on a value of 64 µm.

Next, the samples were fired for 18 hours in a forming-gas atmosphere at a temperature of 1350°C.

Next, as the metal plating film, a Ni plating layer was formed in a thickness of 4 µm and a Au plating layer was formed in a thickness of 0.4 µm. In this way, there were fabricated ceramic substrates having the metal plating film-covered conductor formed on their top surfaces.

Then, laser light was applied to the ceramic substrate thus obtained from above the conductor including the metal plating film for groove-forming machining operation. The irradiation of laser light was effected with use of a 355 nm-wavelength YAG laser-equipped laser scribing apparatus having a placement table which is movable in one axial direction while carrying a workpiece. Under the condition where power output at a processed point stands at 4.9 W under a pulse frequency of 50 kHz, the machining speed was adjusted so that the V-shaped grooves have different depths, namely 1 µm, 5 µm, 10 µm, 16 µm, and 20 µm, respectively. The groove-forming machining operation was carried out in that way.

Subsequently, a SEM-based image of the surface of the metal plating film was obtained to examine the presence or absence of adhesion of machining chips. Moreover, the ceramic substrate was polished on its side surface in a direction perpendicular to the length of the groove, and the polished surface was ground or otherwise by a cross-section polisher. After that, the section of the V-shaped groove was observed by an electronic microscope to determine the width of the V-shaped groove and the thickness of a glass layer created on the inner surface of the V-shaped groove. In the determination of the thickness of the glass layer, a distance from that part of the V-shaped groove contiguous to the conductor to the surface of the vertical glass layer was derived. This distance was defined as the glass layer thickness. The resultant data will be listed on Table 2.

**Table 2**

| Sample No. | Groove depth (µm) | Glass layer thickness (µm) | Adhesion of machining chips |
|---|---|---|---|
| *31 | 1 | 0.1> | No sign of adhesion |
| 32 | 5 | 0.8 | No sign of adhesion |
| 33 | 10 | 2.7 | No sign of adhesion |
| 34 | 16 | 3.4 | No sign of adhesion |
| *35 | 20 | 5.3 | Adhesion noticed |

| | | | |
|---|---|---|---|
| Asterisk (*) denotes samples beyond the scope of the invention | | | |

It is apparent from Table 2 that Samples Nos. 31 through 35 which are Examples of the invention are each free from adhesion of machining chips to the metal plating film.

On the other hand, it has been found that Sample No. 31 having the dividing groove whose depth is less than 5 µm, while being free from adhesion of machining chips to the metal plating film, is configured so that the thickness of the glass layer in a given measured section is less than 0.5 µm. That is, the side surface of the conductor was exposed in part, wherefore the glass layer failed to suppress oxidative corrosion of the conductor satisfactorily.

Furthermore, Sample No. 35 having the dividing groove whose depth is greater than 16 µm was confirmed to suffer adhesion of machining chips to the metal plating film.

### Reference Signs List

1: Ceramic base body
11: Wiring substrate region
111: Periphery
12: Demarcation line
2: Conductor
21: Metal plating film
22: Conductor
3, 30: Dividing groove
31: Glass layer
311: Convexity
4: Lid body
5: Semiconductor device

## Claims

1. A segmentable wiring board, comprising:
a ceramic base body (1) having a plurality of wiring substrate regions (11) and dividing grooves (3, 30) formed in boundaries among the plurality of wiring substrate regions (11) ;
a conductor (2, 21, 22) located in a periphery of each of the plurality of wiring substrate regions (11); and
a glass layer (31) coveringly extending from an inner surface of each of the dividing grooves (3, 30) of the ceramic base body (1) to the conductor (2, 21, 22),
the glass layer (31) having an upwardly-protruding convexity (311) located on the conductor (2, 21, 22),
**characterized in that** the upwardly-protruding convexity (311) having a height of 4.5 µm to 32 µm.

2. The segmentable wiring board according to claim 1,
wherein the conductor (2, 21, 22) is situated under the convexity (311) of the glass layer (31) and upwardly protrudes.

3. The segmentable wiring board according to claim 1,
wherein a thickness of the conductor (2, 21, 22) falls in a range of 20 µm to 80 µm.

4. The segmentable wiring board according to claim 1,
wherein a depth of each of the dividing grooves (3, 30) falls in a range of 5 µm to 16 µm.

5. The segmentable wiring board according to claim 4,
wherein the depth of each of the dividing grooves (3, 30) falls in a range of 30% to 62% of a thickness of the ceramic base body (1).

6. A wiring substrate, comprising:
a ceramic base body (1);
a conductor (2, 21, 22) located in a periphery of a first main surface of the ceramic base body (1); and
a glass layer (31) which covers a side surface of the ceramic base body (1) and a side surface of the conductor (2, 21, 22),
the glass layer (31) having an upwardly-protruding convexity (311) located on the conductor (2, 21, 22),
**characterized in that** the upwardly-protruding convexity (311) having a height of 4.5 µm to 32 µm.

7. The wiring substrate according to claim 6,
wherein the conductor (2, 21, 22) is situated under the convexity (311) of the glass layer (31) and upwardly protrudes.

8. A method for producing a segmentable wiring board, comprising:
a step of forming a composite body including a ceramic base body (1) having a plurality of wiring substrate regions (11) and a conductor (2, 21, 22) located in a periphery of each of the plurality of wiring substrate regions (11); and
a step of forming dividing grooves (3, 30) in the ceramic base body (1) by applying laser light of wavelengths in an ultraviolet region penetratingly to the conductor (2, 21, 22), and forming a glass layer (31) so as to cover an inner surface of each of the dividing grooves (3, 30) of the ceramic base body (1) and a side surface of the conductor (2, 21, 22), the glass layer (31) having an upwardly-protruding convexity (311) located on the conductor (2, 21, 22),
**characterized in that** the upwardly-protruding convexity (311) having a height of 4.5 µm to 32 µm.

9. The method for producing a segmentable wiring board according to claim 8,
wherein, in the step of forming the composite body, the conductor (2, 21, 22) is so formed that a thickness of the conductor (2, 21, 22) falls in a range of 20 µm to 80 µm.

10. The method for producing a segmentable board substrate according to claim 8,
wherein, in the step of forming the dividing grooves (3, 30) by applying laser light of wavelengths in the ultraviolet region to the conductor (2, 21, 22) and forming the glass layer (31), the dividing grooves (3, 30) are so formed that a depth of each of the dividing grooves (3, 30) falls in a range of 5 µm to 16 µm.

11. The method for producing a segmentable wiring board according to claim 8,
wherein, in the step of forming the dividing grooves (3, 30) by applying laser light of wavelengths in the ultraviolet region to the conductor (2, 21, 22) and forming the glass layer (31), the dividing grooves (3, 30) are so formed that a depth of each of the dividing grooves (3, 30) falls in a range of 30% to 62% of a thickness of the ceramic base body (1).

12. A method for producing a wiring substrate, comprising:
a step of dividing the segmentable wiring board constructed by the method for producing a segmentable wiring board according to claim 8, along the dividing grooves (3, 30), into a plurality of wiring substrates.

## Patentansprüche

1. Eine segmentierbare Verdrahtungsplatte aufweisend:
einen keramischen Basiskörpers (1), der eine Mehrzahl von Verdrahtungssubstrat-Regionen (11) und Trennnuten (3, 30) hat, die in Grenzen zwischen der Mehrzahl von Verdrahtungssubstrat-Regionen (11) gebildet sind,
einen Leiter (2, 21, 22), der in einem Randbereich jeder der Mehrzahl von Verdrahtungssubstrat-Regionen (11) angeordnet ist, und
eine Glasschicht (31), die sich bedeckend von einer Innenfläche von jeder der Trennnuten (3, 30) des keramischen Basiskörpers (1) zu dem Leiter (2, 21, 22) erstreckt,
wobei die Glasschicht (31) eine nach oben vorstehende Konvexität bzw. Ausbauchung (311) hat, die an dem Leiter (2, 21, 22) angeordnet ist, **dadurch gekennzeichnet, dass** die nach oben vorstehende Ausbauchung (311) eine Höhe von 4,5µm bis 32µm hat.

2. Die segmentierbare Verdrahtungsplatte gemäß Anspruch 1,
wobei der Leiter (2, 21, 22) unter der Ausbauchung (311) der Glasschicht (31) angeordnet ist und nach oben vorsteht.

3. Die segmentierbare Verdrahtungsplatte gemäß Anspruch 1,
wobei eine Dicke des Leiters (2, 21, 22) in einen Bereich von 20µm bis 80µm fällt.

4. Die segmentierbare Verdrahtungsplatte gemäß Anspruch 1,
wobei eine Tiefe jeder der Trennnuten (3, 30) in einen Bereich von 5µm bis 16µm fällt.

5. Die segmentierbare Verdrahtungsplatte gemäß Anspruch 4,
wobei die Tiefe jeder der Trennnuten (3, 30) in einen Bereich von 30% bis 62% einer Dicke des keramischen Basiskörpers (1) fällt.

6. Ein Verdrahtungssubstrat aufweisend:
einen keramischen Basiskörper (1),
einen Leiter (2, 21, 22), der in einem Randbereich einer ersten Hauptfläche des keramischen Basiskörpers (1) angeordnet ist, und
eine Glasschicht (31), die eine Seitenfläche des keramischen Basiskörpers (1) und eine Seitenfläche des Leiters (2, 21, 22) bedeckt,
wobei die Glasschicht (31) eine nach oben vorstehende Ausbauchung (311) hat, die an dem Leiter (2, 21, 22) angeordnet ist, **dadurch gekennzeichnet, dass** die nach oben vorstehende Ausbauchung (311) eine Höhe von 4,5µm bis 32µm hat.

7. Das Verdrahtungssubstrat gemäß Anspruch 6,
wobei der Leiter (2, 21, 22) unter der Ausbauchung (311) der Glasschicht (31) angeordnet ist und nach oben vorsteht.

8. Ein Verfahren zum Herstellen einer segmentierbaren Verdrahtungsplatte, aufweisend:
einen Schritt des Bildens eines Verbundkörpers, der einen keramischen Basiskörper (1) aufweist, der eine Mehrzahl von Verdrahtungssubstrat-Regionen (11) und einen Leiter (2, 21, 22) hat, der in einem Randbereich jeder der Mehrzahl von Verdrahtungssubstrat-Regionen (11) angeordnet ist, und
einen Schritt des Bildens von Trennnuten (3, 30) in dem keramischen Basiskörper (1) durch durchdringendes Applizieren von Laserlicht mit Wellenlängen in einem ultravioletten Bereich auf den Leiter (2, 21, 22) und Bilden einer Glasschicht (31), um eine Innenfläche jeder der Trennnuten (3, 30) des keramischen Basiskörpers (1) und eine Seitenfläche des Leiters (2, 21, 22) abzudecken, wobei die Glasschicht (31) eine nach oben vorstehende Ausbauchung (311) hat, die an dem Leiter (2, 21, 22) angeordnet ist, **dadurch gekennzeichnet, dass** die nach oben vorstehende Ausbauchung (311) eine Höhe von 4,5µm bis 32µm hat.

9. Das Verfahren zum Herstellen einer segmentierbaren Verdrahtungsplatte gemäß Anspruch 8,
wobei bei dem Schritt des Bildens des Verbundkörpers, der Leiter (2, 21, 22) so gebildet wird, dass eine Dicke des Leiters (2, 21, 22) in einen Bereich von 20µm bis 80µm fällt.

10. Das Verfahren zum Herstellen eines segmentierbaren Plattensubstrats gemäß Anspruch 8,
wobei bei dem Schritt des Bildens der Trennnuten (3, 30) durch das Applizieren von Laserlicht mit Wellenlängen in dem ultravioletten Bereich auf den Leiter (2, 21, 22) und Bilden der Glasschicht (31), die Trennnuten (3, 30) so gebildet werden, dass eine Tiefe jeder der Trennnuten (3, 30) in einen Bereich von 5µm bis 16µm fällt.

11. Das Verfahren zum Herstellen einer segmentierbaren Verdrahtungsplatte gemäß Anspruch 8,
wobei bei dem Schritt des Bildens der Trennnuten (3, 30) durch das Applizieren von Laserlicht mit Wellenlängen in dem ultravioletten Bereich auf den Leiter (2, 21, 22) und Bilden der Glasschicht (31), die Trennnuten (3, 30) so gebildet werden, dass eine Tiefe jeder der Trennnuten (3, 30) in einen Bereich von 30% bis 62% einer Dicke des keramischen Basiskörpers (1) fällt,

12. Ein Verfahren zum Herstellen eines Verdrahtungssubstrats, aufweisend:
einen Schritt des Teilens der segmentierbaren Verdrahtungsplatte, die durch das Verfahren zum Herstellen einer segmentierbaren Verdrahtungsplatte gemäß Anspruch 8 konstruiert wurde, entlang der Trennnuten (3, 30) in eine Mehrzahl von Verdrahtungssubstraten.

## Revendications

1. Carte de câblage segmentable, comprenant :
un corps de base en céramique (1) ayant une pluralité de régions substrats de câblage (11) et des rainures de séparation (3, 30) formées aux limites entre la pluralité de régions substrats de câblage (11) ;
un conducteur (2, 21, 22) situé en périphérie de chaque région de la pluralité de régions substrats de câblage (11) ; et
une couche de verre (31) s'étendant de façon couvrante depuis une surface interne de chacune des rainures de séparation (3, 30) du corps de base en céramique (1) jusqu'au conducteur (2, 21, 22),
la couche de verre (31) ayant une convexité faisant saillie vers le haut (311) située sur le conducteur (2, 21, 22),
**caractérisée en ce que** la convexité faisant saillie vers le haut (311) a une hauteur de 4,5 *µ*m à 32 *µ*m.

2. Carte de câblage segmentable selon la revendication 1,
dans laquelle le conducteur (2, 21, 22) est situé sous la convexité (311) de la couche de verre (31) et fait saillie vers le haut.

3. Carte de câblage segmentable selon la revendication 1,
dans laquelle l'épaisseur du conducteur (2, 21, 22) se situe dans une gamme de 20 *µ*m à 80 *µ*m.

4. Carte de câblage segmentable selon la revendication 1,
dans laquelle la profondeur de chacune des rainures de séparation (3, 30) se situe dans une gamme de 5 *µ*m à 16 *µ*m.

5. Carte de câblage segmentable selon la revendication 4,
dans laquelle la profondeur de chacune des rainures de séparation (3, 30) se situe dans une gamme de 30 % à 62 % de l'épaisseur du corps de base en céramique (1).

6. Substrat de câblage, comprenant :
un corps de base en céramique (1) ;
un conducteur (2, 21, 22) situé en périphérie d'une première surface principale du corps de base en céramique (1) ; et
une couche de verre (31) qui recouvre une surface latérale du corps de base en céramique (1) et une surface latérale du conducteur (2, 21, 22),
la couche de verre (31) ayant une convexité faisant saillie vers le haut (311) située sur le conducteur (2, 21, 22),
**caractérisé en ce que** la convexité faisant saillie vers le haut (311) a une hauteur de 4,5 *µ*m à 32 *µ*m.

7. Substrat de câblage selon la revendication 6,
dans lequel le conducteur (2, 21, 22) est situé sous la convexité (311) de la couche de verre (31) et fait saillie vers le haut.

8. Procédé de production d'une carte de câblage segmentable, comprenant :
une étape de formation d'un corps composite comportant un corps de base en céramique (1) ayant une pluralité de régions substrats de câblage (11) et un conducteur (2, 21, 22) situé en périphérie de chaque région de la pluralité de régions substrats de câblage (11) ; et
une étape de formation de rainures de séparation (3, 30) dans le corps de base en céramique (1) par application de lumière laser de longueurs d'onde dans un domaine ultraviolet de façon pénétrante au conducteur (2, 21, 22), et de formation d'une couche de verre (31) de manière à recouvrir une surface interne de chacune des rainures de séparation (3, 30) du corps de base en céramique (1) et une surface latérale du conducteur (2, 21, 22), la couche de verre (31) ayant une convexité faisant saillie vers le haut (311) située sur le conducteur (2, 21, 22),
**caractérisé en ce que** la convexité faisant saillie vers le haut (311) a une hauteur de 4,5 *µ*m à 32 *µ*m.

9. Procédé de production d'une carte de câblage segmentable selon la revendication 8,
dans lequel, à l'étape de formation du corps composite, le conducteur (2, 21, 22) est formé de telle sorte que l'épaisseur du conducteur (2, 21, 22) se situe dans une gamme de 20 *µ*m à 80 *µ*m.

10. Procédé de production d'un substrat de carte segmentable selon la revendication 8,
dans lequel, à l'étape de formation des rainures de séparation (3, 30) par application de lumière laser de longueurs d'onde dans le domaine ultraviolet au conducteur (2, 21, 22) et de formation de la couche de verre (31), les rainures de séparation (3, 30) sont formées de telle sorte que la profondeur de chacune des rainures de séparation (3, 30) se situe dans une gamme de 5 *µ*m à 16 *µ*m.

11. Procédé de production d'une carte de câblage segmentable selon la revendication 8,
dans lequel, à l'étape de formation des rainures de séparation (3, 30) par application de lumière laser de longueurs d'onde dans le domaine ultraviolet au conducteur (2, 21, 22) et de formation de la couche de verre (31), les rainures de séparation (3, 30) sont formées de telle sorte que la profondeur de chacune des rainures de séparation (3, 30) se situe dans une gamme de 30 % à 62 % de l'épaisseur du corps de base en céramique (1).

12. Procédé de production d'un substrat de câblage, comprenant :
une étape de séparation de la carte de câblage segmentable construite par le procédé de production d'une carte de câblage segmentable selon la revendication 8, le long des rainures de séparation (3, 30), en une pluralité de substrats de câblage.
